# FASCICULE DE BREVET EUROPEEN

(11) **EP 0 442 789 B1**
(45) Date de publication et mention de la délivrance du brevet: **01.12.1993**
(21) Numéro de dépôt: 91400314.0
(22) Date de dépôt: 08.02.1991
(51) Int. Cl.: H01L 33/00, E05B 49/00

(54) **Système de télécommande notamment pour le verrouillage/déverrouillage de portières pour véhicules automobiles**
Fernsteuerungssystem, insbesondere zum Schliessen/Öffnen von Autotüren
Remote control system, particularly to lock/unlock car doors

(30) Priorité: 09.02.1990 FR 9001540
(43) Date de publication de la demande: 21.08.1991
(73) Titulaire: VALEO NEIMAN, 78290 Croissy-sur-Seine (FR)
(72) Inventeur: Rydel, Charles, F-75019 Paris (FR)
(74) Mandataire: Schrimpf, Robert

(56) Documents cités:
- DE-A- 2 632 462
- DE-A- 3 803 541
- FR-A- 2 285 722
- FR-A- 2 352 313
- PATENT ABSTRACTS OF JAPAN, vol. 8, no. 66 (E-234)[1503], 28 mars 1984; & JP-A-58 216 479 (STANLEY DENKI K.K.) 16-12-1983
- PATENT ABSTRACTS OF JAPAN, vol. 9, no. 49 (E-300)[1772], 2 mars 1985; & JP-A-59 189 686 (ROO MU K.K.) 27-10-1984

## Description

La présente invention concerne le domaine des systèmes de télécommande, notamment pour liaison infrarouge.

La présente invention s'applique tout particulièrement aux systèmes de télécommande pour le verrouillage et le déverrouillage de portières de véhicules automobiles.

Les systèmes de télécommande connus comprennent généralement, au niveau de l'émetteur, des moyens formant source de lumière aptes à générer un flux lumineux codé, associés à des moyens optiques adaptés pour configurer le faisceau généré par la source de lumière.

Le document PATENT ABSTRACTS OF JAPAN, vol. 8, n°66 (E-234) (1503), 25 Mars 1984 & JP-A-58216479, décrit une diode émettrice de lumière comprenant une lentille de sortie formée par la combinaison d'au moins deux sphères de rayons différents et de centres décalés, afin d'accroître l'intensité lumineuse axiale.

Le document FR-A-2352313 décrit une optique destinée à la transformation du diagramme d'émission d'une source de lumière. Plus précisément, cette optique a pour but de transformer le diagramme d'émission pluridirectionnelle d'une source de lumière localisée sensiblement dans la région médiane de son plan de base en un diagramme à relativement forte intensité axiale. A cette fin, il est proposé dans ce document que l'optique, considérée depuis son sommet vers son plan de base, soit limitée, au moins partiellement, par une calotte sphérique dont le centre de courbure est situé entre ledit sommet et ladite source, que prolonge sans décrochement au moins une zone sphérique dont le centre de courbure est situé entre celui de ladite calotte sphérique et ladite source. Cette optique peut notamment trouver application dans un ensemble de commande à distance, notamment d'un récepteur de télévision. En effet, selon ce document, grâce à cette optique, si la commande à portée maximum (sur l'axe) demeure directive, la commande à moyenne et courte distance devient beaucoup plus souple, l'intensité lumineuse latérale pouvant alors suffir pour assurer la commande désirée.

La présente invention a pour but principal de proposer de nouveaux moyens permettant d'optimiser la portée de l'émetteur.

La définition des systèmes de télécommande conformes à la présente invention, répondant au but précité, est donnée dans les revendications annexées.

D'autres caractéristiques, buts et avantages de la présente invention apparaîtront à la lecture de la description détaillée qui va suivre, et en regard des dessins annexés, donnés à titre d'exemples non limitatifs et sur lesquels :
- la figure 1 représente schématiquement un système de télécommande pour le verrouillage/déverrouillage de portières de véhicules automobiles conforme à la présente invention,
- la figure 2 représente schématiquement le lobe d'émission de l'émetteur conforme à la présente invention dans un plan de coupe axial passant par l'axe directeur, et
- la figure 3, représente schématiquement, en coupe axiale, un mode de réalisation de moyen conforme à la présente invention.

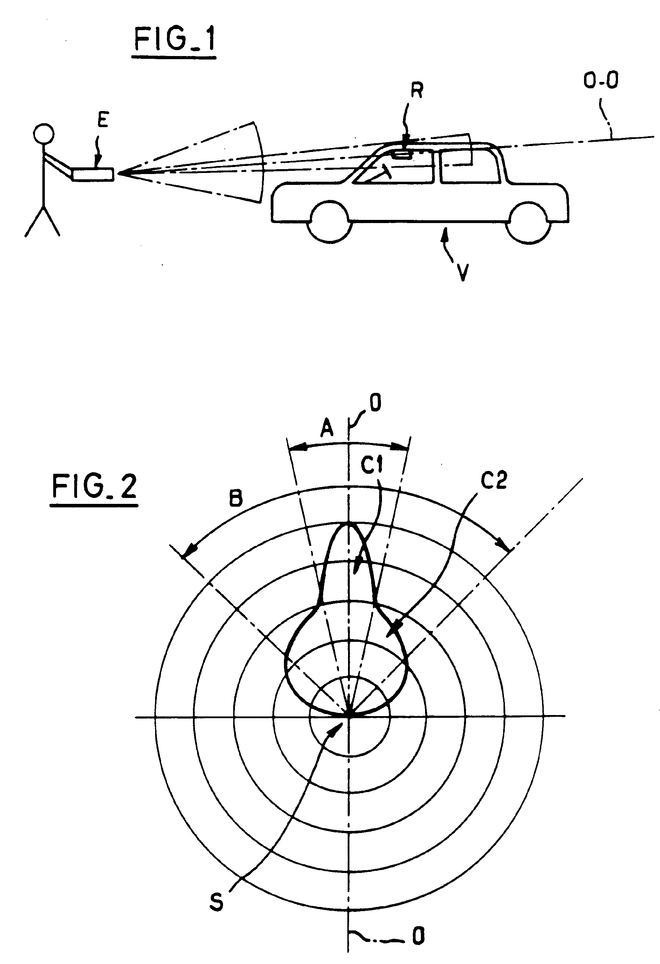

On a représenté schématiquement sur la figure 1 annexée, un système de télécommande conforme à la présente invention conçu pour assurer le verrouillage/déverrouillage à distance d'un véhicule automobile V. Ce système comprend un émetteur E et un récepteur R.

L'émetteur E est placé dans un boîtier portatif. Il est conçu pour générer une onde électromagnétique codée, le plus souvent un rayonnement infrarouge.

Le récepteur R est placé dans le véhicule V. Il est conçu pour recevoir et décoder le signal généré par l'émetteur E.

Lorsque le signal reçu par le récepteur R correspond à un code prédéterminé, le récepteur R contrôle le verrouillage/déverrouillage respectivement des portières du véhicule automobile.

De nombreux systèmes émetteurs et récepteurs ont déjà été proposés à cette fin.

Pour cette raison, la structure de l'émetteur E et du récepteur R ne sera pas décrite en détail par la suite.

Dans le cadre de la présente demande de brevet, on se contentera de décrire l'étage finale de l'émetteur E composé comme indiqué précédemment par une source de lumière associée à des moyens optiques de configuration.

On a représenté schématiquement sur la figure 2 le lobe d'émission de l'émetteur E conforme à l'invention.

Sur la figure 2 on a référencé O-O l'axe directeur de l'émetteur. Par ailleurs, sur la figure 2, la source lumineuse placée au centre du diagramme est référencée S.

Plus précisément la figure 2 représente le lobe d'émission dans un plan axial, c'est-à-dire passant par l'axe directeur O-O. En réalité, le lobe d'émission est symétrique de révolution autour de cet axe directeur O-O.

Sur la figure 2 les différents cercles concentriques, centrés sur la source S, représentent la portée de l'émetteur.

Comme on le voit sur la figure 2, le lobe d'émission conforme à l'invention est formée de deux composantes C1, C2. La première composante C1 centrée sur l'axe directeur O-O présente une grande portée mais un angle d'ouverture A relativement faible. En revanche, la seconde composante C2 qui entoure la première composante C1 et est également centrée sur l'axe directeur O-O présente une plus faible portée que la première composante mais un angle d'ouverture supérieur. Cet angle d'ouverture supérieure est référencé B sur la figure 2.

Plus précisément, encore selon la représentation schématique donnée sur la figure 2, la première composante C1 présente une ouverture angulaire A de l'ordre de 30° soit plus ou moins 15° de part et d'autre de l'axe directeur O-O.

La seconde composante C2 présente une plus grande ouverture angulaire B de l'ordre de 90°, soit plus ou moins 45° de part et d'autre de l'axe directeur O-O, mais une portée de 2 à 2,5 fois plus faible que la première composante C1.

Selon l'invention, la source de lumière et les moyens optiques de configuration associés prennent de préférence la forme de diodes électroluminescentes dans le domaine infrarouge.

Selon une technique connue, de préférence le cristal est noyé dans une masse de matière plastique transparente. Il peut s'agir par exemple de polyméthylméthacrylate PMMA.

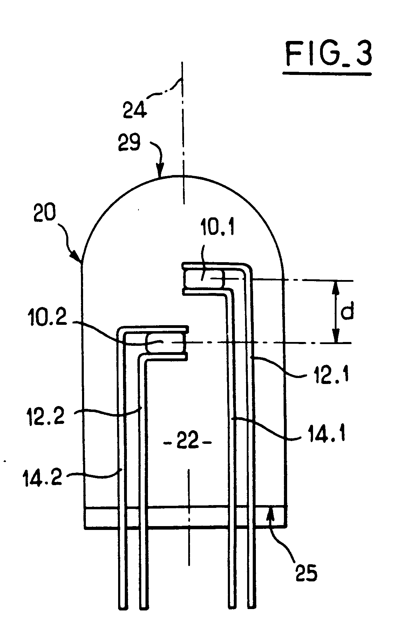

On a représenté sur la figure 3 un mode de réalisation d'une diode photo-émissive conforme à la présente invention.

Selon cette figure 3, la face avant du corps de la diode est délimitée par une calotte sphérique unique 29 centrée sur un point passant par l'axe 24. Par contre, il est prévu deux cristaux électroluminescents 10.1, 10.2 associés respectivement à des paires d'électrodes 12.1, 14.1 et 12.2. et 14.2. Les cristaux 10.1, 10.2 sont tous deux placés au voisinage de l'axe 24, de préférence respectivement de part et d'autre de celui-ci. Par ailleurs, les cristaux 10.1 et 10.2 sont décalés axialement d'une distance d.

La coopération du cristal 10.1 le plus avant et de la face avant 29 de la diode permet de définir la première composante C1 du lobe d'émission. La coopération du second cristal 10.2 le plus arrière et de la surface avant 29 de la diode permet de définir la seconde composante C2 du lobe d'émission.

Selon un autre mode de réalisation la partie émissive est formée de deux diodes juxtaposées présentant des distances différentes entre leur cristal émetteur et le centre des surfaces de sortie sphériques respectives.

## Revendications

1. Système de télécommande, en particulier pour le verrouillage et le déverrouillage de portières de véhicules automobiles du type comprenant des moyens formant source de lumière associés à des moyens optiques adaptés pour configurer le faisceau généré par la source de lumière, caractérisé par le fait que les moyens optiques comprennent un bloc unique de matériau transparent (22) définissant une calotte sphérique de sortie (29) et la source de lumière comprend deux cristaux émissifs par électroluminescence (10.1, 10.2) décalés dans ledit bloc (22) selon l'axe longitudinal.

2. Système de télécommande, en particulier pour le verrouillage et le déverrouillage de portières de véhicules automobiles du type comprenant des moyens formant source de lumière associés à des moyens optiques adaptés pour configurer le faisceau généré par la source de lumière, caractérisé par le fait qu'il comprend deux diodes photo-émissives juxtaposées présentant des distances différentes entre leurs cristaux respectifs (10) et leurs faces de sortie sphériques (29).

## Claims

1. A remote control system in particular for locking and unlocking the doors of motor vehicles, the system being of the type including light source forming means associated with optical means adapted to configure the beam generated by the light source, the system being characterized by the fact that the optical means comprise a unique block of transparent material (22) defining an outlet spherical cap (29) and the source of light comprises two light-emitting crystals (10.1, 10.2) which are offset according to the longitudinal axis in the block (22).

2. A remote control system in particular for locking and unlocking the doors of motor vehicles, the system being of the type comprising light source forming means associated with optical means adapted to configurate the beam generated by the light source, characterized by the fact that it includes two juxtaposed light emitting diodes having different distances between their respective crystals (10) and their spherical outlet faces (29).

## Patentansprüche

1. Fernsteuerungssystem, insbesondere zum Schließen/Öffnen von Autotüren, enthaltend Mittel, die als Lichtquelle dienen, in Verbindung mit optischen Mitteln zur Ausformung des von der Lichtquelle erzeugten Strahlenbündels, **dadurch gekennzeichnet,** daß die optischen Mittel einen einzigen Block aus transparentem Material (22) einschließen, der eine kugelförmige Austrittskappe (29) begrenzt, und daß die Lichtquelle zwei Elektrolumineszenzkristalle (10.1, 10.2) enthält, die im genannten Block (22) entsprechend der Längsachse versetzt sind.

2. Fernsteuerungssystem, insbesondere zum Schließen/Öffnen von Autotüren, enthaltend Mittel, die als Lichtquelle dienen, in Verbindung mit optischen Mitteln zur Ausformung des von der Lichtquelle erzeugten Strahlenbündels, **dadurch gekennzeichnet,** daß es zwei nebeneinanderliegende Fotoemissionsdioden enthält, die in ihren entsprechenden Kristallen (10) und ihren kugelförmigen Austrittsflächen (29) unterschiedliche Abstände aufweisen.
